# EUROPEAN PATENT SPECIFICATION

(11) **EP 3 637 457 B1**
(45) Date of publication and mention of the grant of the patent: **22.04.2026**
(21) Application number: 18199405.4
(22) Date of filing: 09.10.2018
(51) Int. Cl.: H10D 30/01, H10D 12/01, H10D 30/66, H10D 12/00, H10D 64/00

(54) **TRANSISTOR DEVICE AND METHOD FOR FORMING A RECESS FOR A TRENCH GATE ELECTRODE**
TRANSISTORVORRICHTUNG UND VERFAHREN ZUR HERSTELLUNG EINER VERTIEFUNG FÜR EINE GRABEN-GATE-ELEKTRODE
DISPOSITIF DE TRANSISTOR ET PROCÉDÉ DE FORMATION D'UN ÉVIDEMENT DESTINÉ À UNE ÉLECTRODE DE GRILLE DE TRANCHÉE

(43) Date of publication of application: 15.04.2020
(73) Proprietor: Infineon Technologies Austria AG, 9500 Villach (AT)
(72) Inventor: FEIL, Thomas, 9523 Villach (AT); BHANDARI, Jyotshna, 9500 Villach (AT); GRUBER, Christoph, 9241 Wernberg (AT); HOFER, Heimo, 9551 Bodensdorf (AT); JOSHI, Ravi Keshav, 9020 Klagenfurt (AT); KUEHN, Olaf, 01219 Dresden (DE); STEINBRENNER, Juergen, 9611 Noetsch (AT)
(74) Representative: Moore, Joanne Camilla

(56) References cited:
- DE-A1- 102011 054 372
- US-A1- 2008 150 013
- US-A1- 2008 179 668
- US-A1- 2011 291 186
- US-A1- 2016 315 053

## Description

### BACKGROUND

Many functions of modern devices in automobile, consumer and industrial applications, such as controlling electric motors or electrical machines are based on semiconductor transistor devices, such as Field effect transistors such as MOSFETs (Metal Oxide Semiconductor Field Effect Transistor) and IGBTs Insulated Gate Bipolar Transistor).

US 2008/150013 A1 discloses a method for manufacturing a trenched semiconductor power device with a split gate that is separated by an inter-poly insulation layer disposed between a top and a bottom gate segment. The method includes forming the inter-poly layer by applying a rapid thermal anneal after a high density plasma oxide deposition process to bring an etch rate of the oxide layer close to the etch rate of a thermal oxide.

US 2008/179668 A1 discloses a trenched metal oxide semiconductor field effect transistor included a trenched gate. The trenched gate includes at lest two mutually insulated trench-filling segments each filled with materials of different work functions.

US 2016/315053 A1 describes a semiconductor power device comprising a plurality of power transistor cells each having a trenched gate disposed in a gate trench wherein the trenched gate comprising a shielding bottom electrode disposed in a bottom portion of the gate trench electrically insulated from a top gate electrode disposed in a top portion of the gate trench by an inter-electrode insulation layer.

DE 10 2011 054372 A1 describes a method involving forming a vertical trench that extends from a horizontal main surface into a semiconductor body. A dielectric layer is formed in the vertical groove. A conductive region is formed on the dielectric layer in the vertical trench such that the conductive region is retracted from the horizontal main surface. The vertical trench is filled with another dielectric layer. The dielectric layers are removed from an upper portion of the vertical trench to expose the semiconductor body at a side wall of the vertical trench, where the conductive region remains covered.

The capacitance between the gate electrode and the power electrodes, that is a source electrode and a drain electrode for MOSFETs and an emitter electrode and collector electrode for an IGBT and the blocking voltage of the transistor are operating parameters which can be optimised to improve the performance of a transistor device. Buried field plates can be used to increase the blocking voltage for a particular on resistance Rₒₙ. The field plate and the gate electrode may be arranged in a trench, with the field plate arranged towards the bottom of the trench and the gate electrode arranged towards the top of the trench. The gate electrode is electrically isolated from the field plate and from the semiconductor body and the field plate is electrically isolated from the semiconductor body, typically by an insulating material such as an oxide. Whilst the buried field plate can be used to reduce the gate drain capacitance (Qgd), a capacitance arises between the gate electrode and the field plate which forms part of the gate-source capacitance (Qgs), since the field plate is typically coupled to source potential.

The gate-source capacitance can be influenced by adjusting the dielectric constant and the thickness of the isolation layer between the gate electrode and the field plate. However, further improvements are desirable in order to further increase the performance of the transistor device.

### SUMMARY

A method of forming an insulated field plate in a trench and a recess for a gate electrode in the trench as recited in claim 1 is provided. The method comprises forming a trench in a first major surface of a semiconductor substrate, the trench having a base and a side wall extending from the base to the first major surface, forming a first insulating layer on the base and the side wall of the trench, inserting a first conductive material into the trench that at least partially covers the first insulation layer to form a field plate in a lower portion of the trench, applying a second insulating layer to the first major surface and the trench such that the second insulating layer fills the trench and covers the conductive material, removing the second insulating layer from the first major surface, partially removing the second insulating layer from the trench by wet chemical etching and forming a recess for a gate electrode in the second insulating layer in the trench. The inserting the first conductive material comprises filling the trench with the first conductive material and applying the first conductive material over the first major surface, and removing the first conductive material from the first major surface and from an upper portion of the trench to form the field plate in the lower portion of the trench. After the formation of the field plate, the first insulating layer is entirely removed from the side wall at an upper portion of the trench to expose the semiconductor material of the semiconductor substrate. The second insulating layer is selectively removed from the first major surface by chemical mechanical polishing and the first major surface of the semiconductor substrate acts as an etch stop. The method further comprises forming a third insulating layer on the exposed side wall, and inserting a second conductive material into the recess to form a gate electrode in an upper portion of the trench. After forming the gate electrode, the method comprises forming a body region of a second conductivity type by implantation into the first major surface of the semiconductor substrate, the body region forming a pn junction with the semiconductor material of the semiconductor substrate at a depth dₚₙ from the first major surface, and forming a source region on the body region.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figures 1A to 1G illustrate a method for forming a recess for a trench electrode.
Figure 2 illustrates a flowchart of a method for forming a recess for a trench gate electrode.
Figure 3 illustrates a transistor device including a trench gate electrode.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

In power MOSFET devices, the gate-drain-capacitance (Qgd) has a strong impact on the switching behavior of the device. The ratio between Qgd and Qgs (gate-source-capacitance) determines the susceptibility to induced turn-on (during turn-off the fast rising drain voltage opens the device via capacitive coupling). The value of the gate-drain-capacitance adds to the switching losses and it impacts the drift behavior of the channel resistance when the device is subject to stress conditions. In order to control these issues, a precise control of the processes is required in order to achieve a precise target value of the gate-drain capacitance and to achieve small variations across each wafer which can be challenging for vertical gate structures.

A geometric equivalent for the Qgd value is the overlap of the lower end of the gate electrode over the end of the body of the transistor. For transistor structures having a trench including a gate electrode positioned on a field plate, also referred to as dual-poly MOSFETs as both the field plate and gate electrode are commonly formed of polysilicon, this geometric value is usually dependent on at least the recess of the lower poly electrode, i.e. the field plate, and the growth of the IPD (inter-poly-dielectric). Using conventional processes for the gate recess etch and the follow-up deposition/growth, variations on the order of >~ +/-40 nm are expected for productive limits.

The embodiments described herein are based on the realization that, for vertical gate structures, the Qgd value can depend on the history of the trench processes before the gate-oxide-growth, since the vertical position of the gate electrode in the trench is defined by the initial recess into the trench, whereas the body implantation is defined with respect to the mesa surface, and the realization that this difference can lead to alignment variations between gate electrode and the MOSFET channel across wafers and lot to lot.

As described herein, a process is provided in which the gate electrode positioning in such vertical dual poly MOSFETs is independent of the trench process history. Consequently, better control of the targeted Qgd value is provided. The gate overlap over the end of the body of the transistor is defined using the following method. In a first step, after the formation of the lower poly-electrode, i.e. field plate, in the lower portion of the trench and the removal of the oxide on the sidewall of the upper portion of the trench above the field plate, the complete trench is refilled with oxide. In the second step the oxide overfill is planarized with a Chemical Mechanical Polishing (CMP) process and the CMP is designed to stop with very high selectivity on the top of the transistor mesa. In some embodiments, silicon removal from the mesa is on the order of a few (2-3) nm only. This method defines a new surface from which both the gate electrode and all implantations are defined. The upper part of the transistor becomes thus independent of all processes involved in forming the lower poly-electrode. Since all of the upper part of the trench is filled with oxide, the lower end of the gate electrode can be defined solely by a wet-chemical etch process used to form a recess for the gate electrode in the upper portion of the trench. In this way the geometrical variation between the overlap of the gate electrode and the body region can be reduced to about +/-15nm. This in turn results in a variation reduction of about a factor of 2.5-3 compared to current standard approaches.

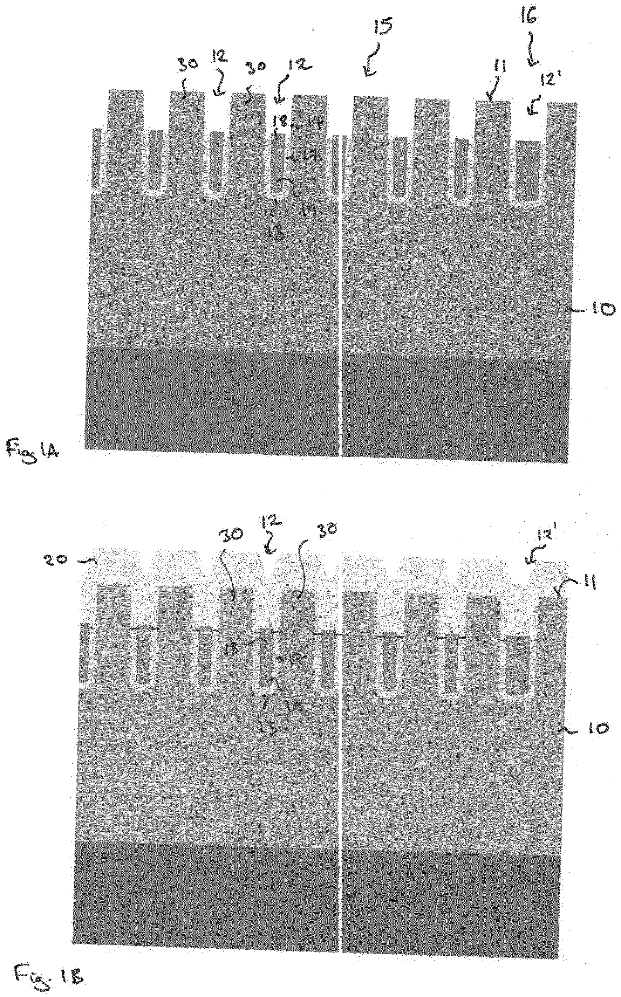

Figures 1A to 1G illustrate a method for forming a recess for a trench gate electrode and for forming trench gate electrode in the recess. The trench gate electrode may be used in a transistor device, such as a MOSFET device.

Figure 1A illustrates a semiconductor substrate 10 which may be a silicon substrate. The silicon substrate may be a single crystal silicon wafer or may include an epitaxially deposited monocrystalline silicon layer, commonly known as an epi layer, arranged on a support substrate which may be single crystal silicon wafer. The semiconductor substrate 10 includes a first major surface 11.

A trench 12 is formed in the first major surface 11 of the semiconductor substrate 10 and has a base 13 and a sidewall 14 extending from the base 13 to the first major surface 11. The trench may extend substantially perpendicularly to the first major surface 11. The first major surface 11 can be described as a lateral or horizontal surface and the trench 12 may be considered to be a vertical trench.

The trench 12 may have an elongate stripe type form with the length of the trench 12 extending into the plane the drawing. Typically, a MOSFET device includes a plurality of trenches 12 extending substantially parallel to one another such that neighbouring trenches 12 define a mesa 30. In other embodiments, the trench 12 may have a columnar form or needle-type form and may be substantially circular, square, hexagonal in plan view. In these embodiments, the region between the columnar trenches forms the mesa.

The side wall 14 continuously borders the base 13 to form the trench 12. In embodiments in which the trench 12 has an elongate strip-like form, the side wall 14 may have two substantially parallel long portions connected by two substantially parallel short portions which extend substantially perpendicularly to the long portions to form a rectangular shape in plan view.

The method will be described in connection with a single trench 12. However, the fabrication of the recess and trench gate electrode is typically carried out for a plurality of trenches essentially simultaneously. The trenches 12 may form part of the active switching area of the transistor device and be positioned in what is commonly referred to as the active area 15 or cell field of the transistor device. Some of the trenches 12' may also be positioned in the edge termination region 16 and form part of the edge termination structure of the transistor device. The trenches 12' in the edge termination region may have one or more dimensions, for example the width, that is different from the dimensions of the trenches 12 in the active area 15.

After the formation of the trench 12 in the first major surface, a first insulating layer 17 is formed on the base 13 and sidewall 14 of the trench 12 and may entirely cover the semiconductor material forming the base 13 and side wall 14 of the trench 12. The first insulating material 17 has a thickness such that it lines the base 13 and side wall 14 and defines a gap or unfilled region at the centre of the width of the trench 12. A first conductive material 18 is inserted into the trench and, in particular, into the gap defined by the first insulating layer 17 to form a field plate 19 in a lower portion of the trench 12.

As illustrated in Figure 1A, the first insulating layer 17 is entirely removed from the sidewall 14 of the trench 12 in the upper portion of the trench 12 so that the semiconductor material of the substrate 10 is exposed. The uppermost portion of the field plate 19 may protrude above the upper surface of the remainder of the first insulating layer 17. In some embodiments, a very thin insulating layer with a thickness of a few nm may be present on the sidewall 14 of the upper portion of the trench 12.

The first conductive material 18 may be inserted into the trench 12 by entirely filling the trench 12 with the first conductive material 18 and applying the first conductive material 18 over the first major surface 11 of the semiconductor substrate 10. The first conductive material 18 is then removed from the first major surface 11, for example by chemical mechanical polishing, and is removed from an upper portion of the trench 12, for example by etching, to form the field plate 19 in the lower portion of the trench 12. The upper portion of the trench 12 is unfilled or empty and may be defined laterally by the semiconductor material of the semiconductor substrate 10 forming the side wall 14 of the trench 12 and be defined at the base by the field plate 19 and the first insulating layer 17 that is laterally arranged between the field plate 19 and the side wall 14. The first insulating layer 17 may be formed of silicon oxide, for example silicon dioxide, and the first conductive material 18 and the field plate 19 may be formed of polysilicon.

Figure 1B illustrates the semiconductor substrate 10 after a second insulating layer 20 has been applied to the first major surface 11 of the semiconductor substrate 10 such that the second insulating layer 20 fills the trench 12 and covers the conductive material 18 and the field plate 19. The second insulting layer 20 covers the portion of the field plate 19 protruding from the first insulating layer 17 and contacts the upper surface and the portions of the side faces of the field plate 19 that are uncovered by the first insulating layer 17. The second insulating layer 20 also contacts the first insulating layer 17 and the side walls 14 of the upper portion of the trench 12 or, if present, the thin oxide layer remaining on the upper portion of the side walls 14 of the trench 12.

The second insulating layer 20 may be conformally deposited such that it has peaks positioned above the mesas 30 and troughs positioned above the trenches 12. The base of the troughs is positioned above the first major surface 11 so that the trenches 12 are completely filled with the second insulating layer 20. The second insulating layer 20 may be deposited using high density plasma deposition (HDP) and may be formed of silicon dioxide.

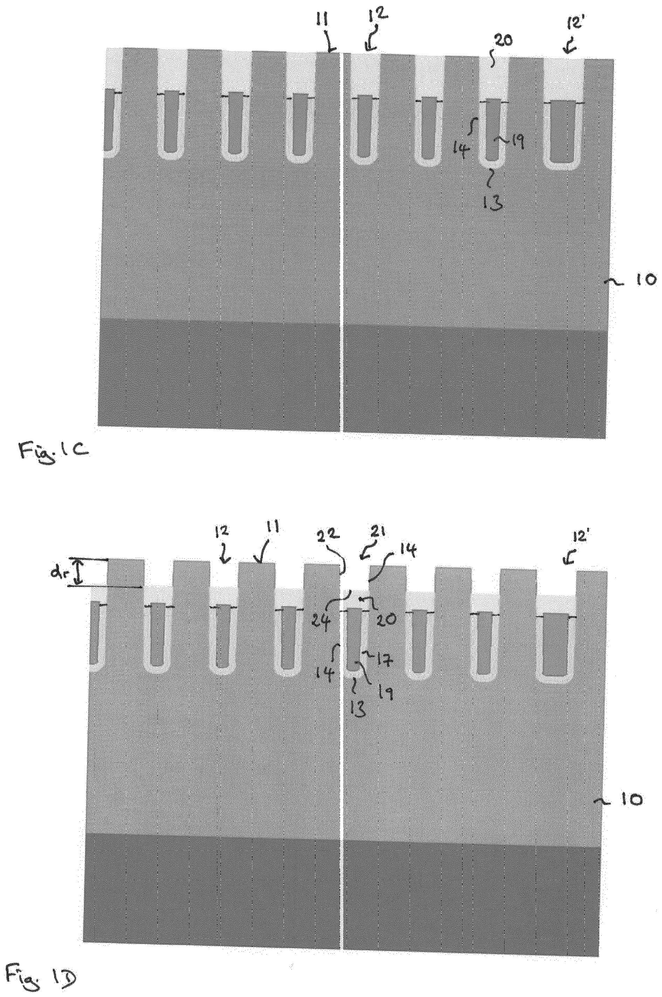

Figure 1C illustrates the semiconductor substrate after the second insulating layer 20 has been removed from the first major surface 11 of the semiconductor substrate 10 such that the semiconductor material of the mesa 30 is exposed and forms the uppermost surface of the semiconductor substrate 10 and such that the second insulating material 20 positioned in the trenches 12 is substantially coplanar with the upper surface of the mesa 30 to provide a planar first major surface 11.

This planar first major surface 11 may then be used to determine the depth of the gate in the trench 12 and position of the implanted regions within the mesas 30 as is described in connection with figures 1D to 1G.

The second insulating layer 20 is partially removed from the trench 12 and a recess 21 for a gate electrode is formed in the second insulating layer 20 in the trench 12, as illustrated in figure 1D. The recess 21 has a base 24 formed by the second insulating material 20 such that it is spaced apart from the field plate 19 by a region of the second insulating layer 20. The second insulating layer 20 provides electrical insulation on top of the field plate 19. The sidewall 22 of the recess 21 is formed by the semiconductor material of the semiconductor substrate 10. The recess 21 has a depth dᵣ such that the base 24 of the recess 21 is positioned at a depth or distance dᵣ from the first major surface 11.

The second insulation layer 20 is removed from the trench 12 to form the recess 21 by wet chemical etching. By using wet chemical etching to remove the second insulating material 20 from the trench 12 and form the recess 21, the depth dᵣ of the recess 21 may be controlled using the first major surface 11, since the first major surface 11 can act as an etch stop. As the top portion of the trench 12 is filled with a single insulation material, i.e. the material of the second insulation layer 20, the wet etching enables the depth dᵣ of the recess 21 to be more precisely controlled.

The second insulating layer 20 is selectively removed with respect to the material of the semiconductor substrate 10. The first major surface 11 of the semiconductor substrate 10 acts as an etch stop. The second insulating layer 20 may be selectively removed by chemical mechanical polishing (CMP). The chemical mechanical polishing may include using a slurry having an polish selectivity of the material of the second insulating layer 20 over the material of the semiconductor substrate of around 100 to 1.

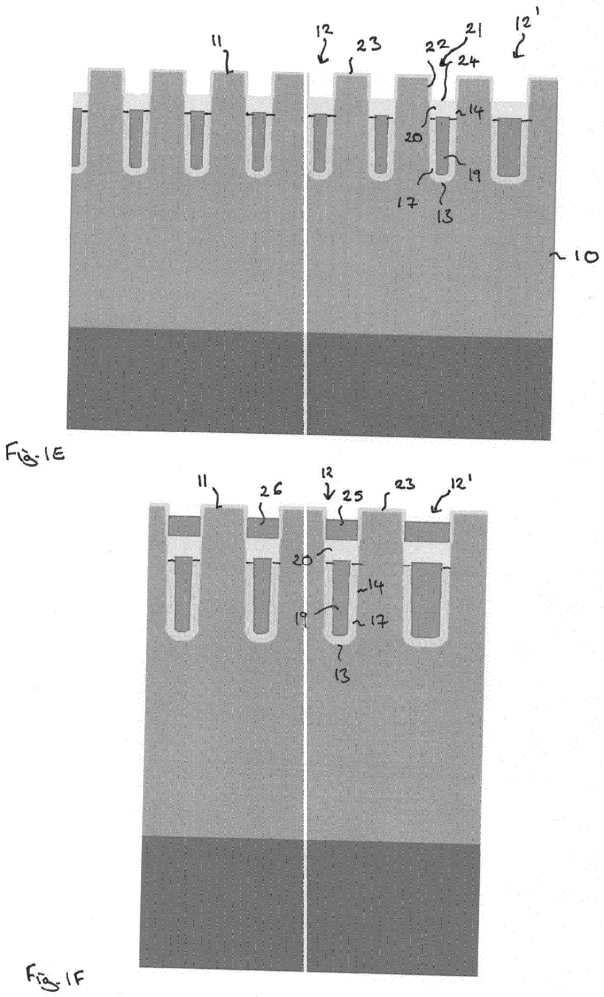

Figure 1E illustrates a semiconductor substrate 10 after a third insulating layer 23 is formed on the exposed sidewall 22 of the recess 21. The third insulating layer 23 forms the gate oxide and is thinner than the first insulating layer 17. In some embodiments, the third insulating layer 23 is conformally deposited and covers the first major surface 11, the sidewall 22 and base 24 of the recess 21.

As is illustrated in figure 1F, a second conductive material 25 is inserted into the recess 21 that now includes the third insulating layer 23 as a gate oxide on at least the side wall 22 to form a gate electrode 26 in an upper portion of the trench 12. The gate electrode 26 is separated from the semiconductor material of the mesa 30 by the third insulating material 23 and from the field plate 19 by the second insulating layer 20. For embodiments in which the gate oxide is deposited on the second insulating layer 20, the gate electrode 26 is separated from the field plate by the gate oxide and the second insulating layer 20.

The first insulating layer 17, the second insulating layer 20 and the third insulating layer 23 may include silicon oxide. The semiconductor substrate 10 may include silicon. The first conductive material 18 forming the field plate 19 and second conductive material 25 forming the gate electrode 26 may comprise polysilicon.

The depth dᵣ of the recess 21 as formed may be the same as the depth d_{g} of the gate electrode in the final device structure, for example if the third insulating layer 23 forming the gate oxide is deposited only on the silicon forming the side wall 22. In some embodiments, the depth dᵣ of the recess may have an offset from d_{g}. For example, the depth dᵣ of the recess may have an offset from d_{g} if the third insulating layer 23 forming gate oxide is deposited onto the base 24 of the recess 21. The depth dᵣ of the recess may have an offset from d_{g} if the third insulating layer 23 forming the gate oxide is formed by thermal annealing, due to the consumption of the top part of the mesa, or due to the effects of other processing parameters, which, for example, affect the upper surface of the mesa, such as thermal oxides, for example screen oxides.

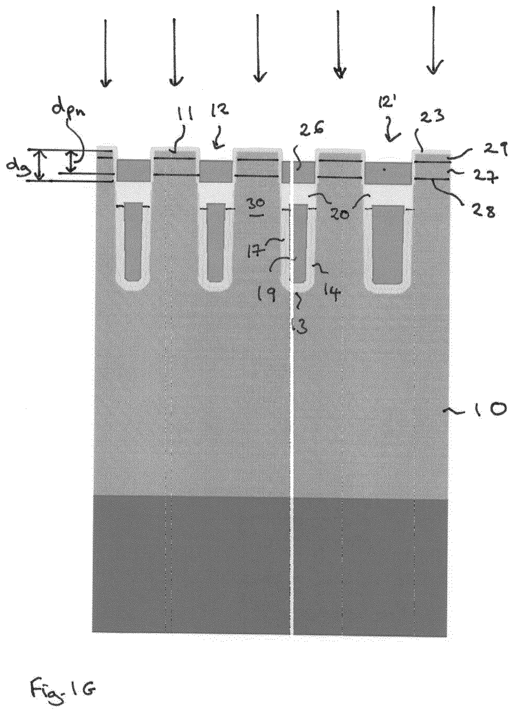

As is illustrated schematically in figure 1G by the arrows, a body region 27 of a second conductivity type may be formed by implantation into the first major surface 11 of the semiconductor substrate 10. The body region 27 forms a pn junction 28 with the underlying semiconductor material of the semiconductor substrate 10, which comprises a first conductivity type which opposes the second conductivity type. For example the semiconductor substrate may be n-type and the body region 27 p-type. The pn junction 28 is formed at a depth dₚₙ from the first major surface 11. A source region 29 comprising the first conductivity type is formed on the body region 27.

The lower surface of the gate electrode 26 is positioned at a depth d_{g} from the first major surface 11. The pn junction 28 between the body region 27 and the underlying semiconductor substrate 10 is arranged at a depth dₚₙ from the first major surface 11. Since both the implantation to form the body region 27 and the wet etch process to form the recess 21 are determined by processes measuring from the position of the first major surface 11, the relationship between the position of the base of the recess 21 and, therefore, the lowermost portion of the gate electrode 26 and the position of the body region 27 and, therefore, pn junction 28 can be more closely controlled. Consequently, the overlap between the gate electrode 26 and body region 27 can be more closely controlled and the gate-drain capacitance Qgd reduced.

In some embodiments, the variation of the difference between the depth dₚₙ and the depth d_{g} is less than 8% of d_{g}. This difference in the depth is the difference in the absolute depths. The difference in the depth may have a distribution defined in terms of sigma. In some embodiments, the variation of the difference between the depth dₚₙ and the depth d_{g} is less than 8% of d_{g} with ±4.5σ. As an example, the depth of the recess dᵣ may be 200 ± 20nm with a distribution of ±4.5σ. If the depth dₚₙ has a variation of ± 10nm for a standard deviation of 4.5σ, the total variation is √(20² + 10²) = √(500) = ± 22.4 nm with ±6.4σ as √(4.5² + 4.5²)= ±6.4σ and the processes are independent.

Not only is the variation in the difference between the depth dₚₙ and depth d_{g} lower for the cells within the cell field of a single transistor device, it is also lower for the edge termination region and wafer-to-wafer and lot-to-lot.

The lower surface of the gate electrode 26 has a depth d_{g} in the final product. The depth dᵣ of the recess directly after its formation may differ from the depth d_{g} in the final product, since growth of the gate oxide takes some silicon of the mesa. If a gate oxide is deposited onto the base of the recess 21, for example the third insulating layer 23 illustrated in Fig. 1E, then the initial recess depth dᵣ is modified by the thickness of the deposited layer. For a deposited gate oxide layer, this thickness is taken into account in the original recess depth dᵣ. As the thickness of the gate oxide layer, is very precisely controlled it should not adversely impact the achieved precision of Q_{gd}.

In some embodiments, the depth dᵣ of the recess 21 may be further controlled by determining the depth dᵣ₁ of the recess 21, comparing the determined depth dᵣ₁ to a predetermined depth and further removing the second insulating layer 21 by, for example, wet chemical etching, and increasing the depth of the recess 21, if the determined depth dᵣ₁ is less than the predetermined depth. This method can be repeated until the determined depth is equal to the depth dᵣ. The composition of the wet chemical etch and/or one or more etching conditions may be adjusted responsive to the determined depth dᵣ₁ of the recess 21.

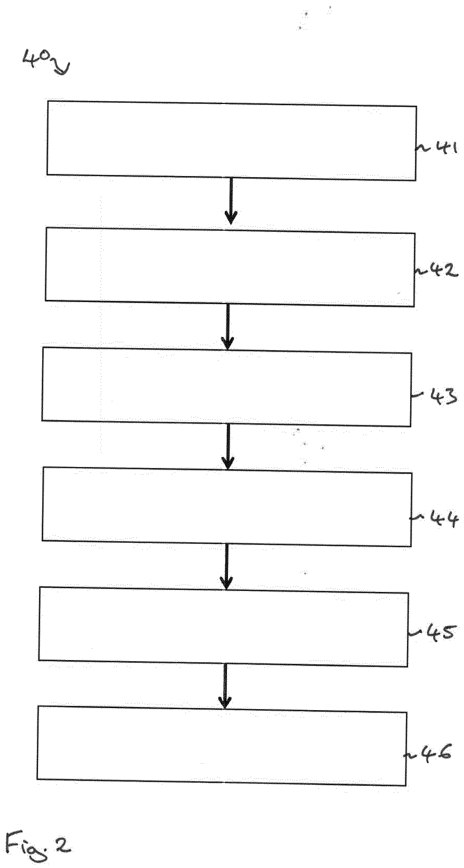

Figure 2 illustrates a flow diagram 40 of a method of forming a recess for a trench gate electrode. In block 41, a trench is formed in a first major surface of a semiconductor substrate, the trench having a base and a side wall extending from the base to the first major surface.

In block 42, a first insulating layer is formed on the base and the side wall of the trench. In block 43, a first conductive material is inserted into the trench so that it at least partially covers the first insulation layer to form a field plate in a lower portion of the trench. In block 44, a second insulating layer is applied to the first major surface and the trench such that the second insulating layer fills the trench and covers the conductive material. In block 45, the second insulating layer is removed from the first major surface. In block 46, the second insulating layer is partially removed from the trench by wet chemical etching and a recess for a gate electrode is formed in the second insulating layer in the trench. The use of wet chemical etching enables the depth of the recess to be controlled compared to the first major surface of the substrate.

The second insulting layer is selectively removed and the first major surface of the semiconductor substrate acts as an etch stop. The control of the depth may be further assisted by the use of chemical mechanical polishing to remove the second insulating layer from the first major surface and the use of a slurry which is selective to the material of the second insulating layer, for example silicon oxide, compared to the material of the semiconductor substrate, for example silicon. The chemical mechanical polishing may be carried out using a slurry having an polish selectivity of the second insulating layer over the semiconductor substrate of around 100 to 1.

The second insulating layer can be deposited onto the first major surface using high density plasma (HDP) deposition. HDP deposition may be used to ensure that the upper portion of the trench is filled completely with a single body comprising the material of the second insulating layer. As different oxides have different etch rates, filling the trench with one type of oxide only enables the control of the depth of the recess and consequently the position of the bottom of the gate electrode in the device and its spacing or depth from the first major surface. The use of a single material to fill the upper portion of the trench further assists in providing a predictable and controllable removal of the second insulating layer from the trench by wet etching and consequently a well-defined depth to the recess and well-defined position of the gate electrode with respect to the first major surface of the semiconductor substrate.

In some embodiments, the removing the second insulating layer from the trench by wet chemical etching comprises exposing semiconductor material at the side wall of the trench above the first conductive material. The first conductive material of the field plate remains covered by the second insulating material.

Before refilling the trench, the first insulating layer, if present on the side wall in the upper part of the trench, may be removed from the side wall by the wet chemical etching to expose the semiconductor material of the semiconductor substrate.

In some embodiments, the recess for the gate electrode may be formed using multiple steps. For example, in an embodiment, the method further comprises determining the depth of the recess, comparing the determined depth to a predetermined depth, and further removing the second insulating layer using wet chemical etching and increasing the depth of the recess. This method may be repeated until the recess has the predetermined depth. A composition of the wet chemical etch and/or an etching condition may be adjusted responsive to the determined depth.

In some embodiments, a composition of the wet chemical etch and/or an etching condition may be adjusted responsive to the determined depth of the recess for the manufacture of subsequent wafers or lot of wafers.

The method further comprises forming a third insulating layer on the exposed side wall to from a gate oxide, and inserting a second conductive material into the recess to form a gate electrode in an upper portion of the trench. The third insulating layer may be formed by deposition of an insulating material into the trench or by oxidation of the semiconductor material of the exposed side wall of the trench.

The first conductive material may be inserted into the trench by filling the trench with the first conductive material and applying the first conductive material over the first major surface, and afterwards removing the first conductive material from the first major surface and from an upper portion of the trench to form the field plate in the lower portion of the trench.

The method further comprises forming a body region of a second conductivity type by implantation into the first major surface of the semiconductor substrate, the body region forming a pn junction with the semiconductor material of the semiconductor substrate at a depth dₚₙ from the first major surface, and forming a source region on the body region. The semiconductor material of the semiconductor substrate which contacts the body region forms a drift region of the transistor structure. A drain region may be formed in the semiconductor substrate underneath the drift region to form a vertical transistor structure such as a vertical MOSFET structure. The drain region may be provided by a semiconductor support substrate which is highly doped, for example with the first conductivity type, with the drift region, body region and source region of the mesa and trench formed in an epitaxial semiconductor layer formed on the support substrate.

The position of the recess and of the gate electrode formed in the recess is independent of the previous methods and processes used to form the field plate in the base of the trench. Consequently, any variation in the position of the field plate is not transferred to the position of the gate electrode. Additionally, since the body region is formed by implantation into the semiconductor substrate from the first major surface, the position of the body region with respect to the first major surface and the depth of the pn junction between the body region and the underlying portion of the semiconductor substrate forming the drift zone is controlled with respect to the same surface, i.e. the first major surface, as that used to control the depth of the gate electrode. Consequently, the difference between the depth of the recess and its gate electrode and the pn junction between the body region and the drift zone can be more accurately defined, not only within the cells of a single transistor device, but also from wafer-to-wafer and from lot-to-lot. Consequently, the gate-drain capacitance can be reduced, not only for a single transistor device, but for multiple wafers and multiple lots of wafers.

In some embodiments, the improved Qgd control process may be implemented as follows. The starting point is a vertical dual-poly transistor with finished lower poly electrode, i.e. field plate. The insulating layer or field oxide FOX at the sidewall at the upper portion of the trench above the field plate has been removed in order to optimize the aspect ratio of the top opening for the oxide-filling of the trench. Depending on the aspect ratio of the trench, this removal of the field oxide could be omitted.

In the next step, the trench is filled with an oxide including an overfill. The height of the overfill can depend on the slurry properties used in the subsequent CMP process. Depending on the slurry requirements of the following planarization, the fill can either transfer the topology or flatten it. If High Density Plasma (HDP) is used to deposit the oxide, a thin protective layer can be grown or deposited before the oxide fill to protect the exposed silicon from plasma damage.

In the next step, the surface is planarized in a CMP process. The process needs to have very high selectivity of the oxide over silicon in order to not significantly impact the trench depth and trench depth variation. The planarization is followed up with necessary cleaning steps which could already lead to a small initial, constant recess of the oxide into the trench.

Finally, the oxide is recessed according to requirements into the trench to produce a recess of the gate electrode. Due to the previous planarization, this recess becomes independent of the process history of the trench. Both gate electrode and implantations are defined from the same surface resulting in an optimized alignment between channel and gate electrode. This allows for a minimization of the resulting overlap of the gate over the channel and helps to reduce/control Qgd. The wet recess etch could be split into multiple parts in order to fine tune the final depth after a first initial etch/measurement. Also a constant offset could be added by a possible wet clean, before the following growth of the gate oxide. An offset can also be used for a deposited gate oxide which reduces the initial size of the recess by the width of the deposited and annealed gate oxide layer.

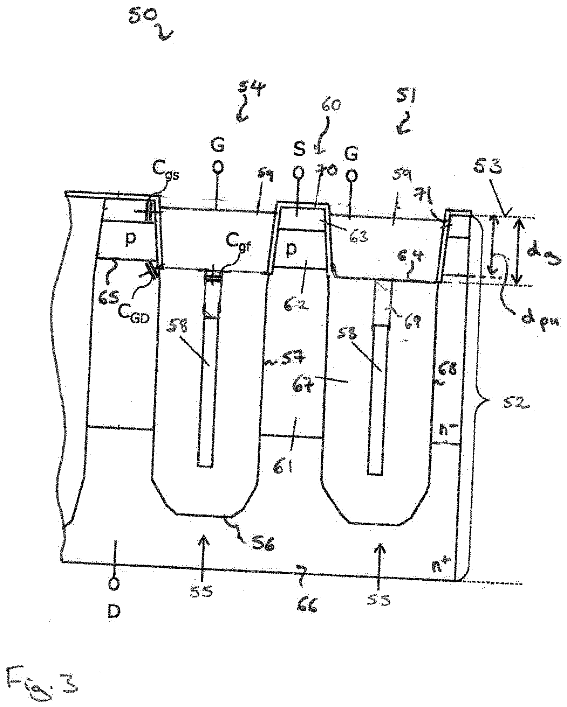

Figure 3 illustrates a transistor device 50, for example a MOSFET device, including a gate structure 51 fabricated using the methods described herein. The transistor device 50 comprises a semiconductor substrate 52 having a first major surface 53 and a plurality of transistor cells 54. Each transistor cell 54 comprises a trench 55 extending substantially perpendicularly from the first major 53 surface into the semiconductor substrate 52 and having a base 56 and a side wall 57 extending from the base 56 to the first major surface 53, a field plate 58 in the trench 55, a gate electrode 59 in the trench 55 arranged above and electrically insulated from the field plate 58. The gate electrode 59 is recessed into the top portion of the trench 55 so that its upper surface lies below the first major surface 53. The transistor cell 54 also includes a mesa 60 defined by neighbouring ones of the trenches 55 which comprises a drift region 61, a body region 62 on the drift region 61 and a source region 63 on the body region 62. A lower surface 64 of the gate electrode 59 is arranged at a depth d_{g} from the first major surface 53 and the body region 62 forms a pn junction 65 with the semiconductor material of the semiconductor substrate 52 at a depth dₚₙ from the first major surface. A variation in the difference between the depth dₚₙ and the depth d_{g} is less than 8% of d_{g}.

The transistor device 50 also includes a drain region 66 on which the drift region 61 is formed. The drain region 66 may be formed in a support substrate such as a highly doped silicon single crystal substrate and the drift region 61, body region 62 and source region 63 may be formed in an epitaxial silicon layer grown on the support substrate. The drain region may form the rear surface of the transistor device 60. The semiconductor substrate 51, drift region 61, source region 63 and drain region 66 have the first conductivity type, for example n-type, and the body region 62 has the second conductivity type, for example p-type.

The trench 55 includes a first insulating layer 67 forming a field oxide which lines the base 56 and lower portion 68 of the side wall 57 and which is laterally positioned between the field plate 58 and the side wall 57. A second insulating layer 69 is positioned on the field plate 58 and extends between the field plate 58 and the gate electrode 59. The top portion of the field plate 58 is covered by the second insulating layer 69. A third insulating layer 70 providing a gate insulation or gate oxide is arranged on portions 71 of the side wall 57 at the top of the trench 55 and extends from the second insulating layer 69 to the first major surface 53 of the semiconductor substrate 52.

As the overlap at the bottom of the gate electrode 59 between the gate electrode 59 and the body region 62 can be more precisely controlled by manufacturing the transistor device 50 using the methods described herein, the gate-drain capacitance can be easily and more precisely controlled and the performance of the transistor device 50 improved.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A method of forming an insulated field plate in a trench and a recess (21) for an insulated gate electrode (26) in the trench, comprising:
forming a trench (12) in a first major surface (11) of a semiconductor substrate (10), the trench (12) having a base (13) and a side wall (14) extending from the base (13) to the first major surface (11);
forming a first insulating layer (17) on the base (13) and the side wall (14) of the trench (12);
inserting a first conductive material (18) into the trench (12) that at least partially covers the first insulation layer (17) to form a field plate (19) in a lower portion of the trench (12) wherein the inserting the first conductive material (18) comprises:
filling the trench (12) with the first conductive material (18) and applying the first conductive material (18) over the first major surface (11), and
removing the first conductive material (18) from the first major surface (11) and from an upper portion of the trench (12) to form the field plate (19) in the lower portion of the trench, and
after the formation of the field plate (19), the first insulating layer (17) is entirely removed from the side wall (14) at an upper portion of the trench (12) to expose the semiconductor material of the semiconductor substrate (10);
applying a second insulating layer (20) to the first major surface (11) and the trench (12) such that the second insulating layer (20) fills the trench (12) and covers the conductive material (18);
removing the second insulating layer (20) from the first major surface (11);
partially removing the second insulating layer (20) from the trench (12) by wet chemical etching and forming a recess (21) for a gate electrode (26) in the second insulating layer (20) in the trench (12),
wherein the second insulating layer (20) is selectively removed from the first major surface (11) by chemical mechanical polishing and the first major surface (11) of the semiconductor substrate (10) acts as an etch stop, and the method further comprises
forming a third insulating layer (23) on the exposed side wall (22), and
inserting a second conductive material (25) into the recess to form a gate electrode (26) in an upper portion of the trench (12), and
after forming the gate electrode (26) forming a body region (27) of a second conductivity type by implantation into the first major surface (11) of the semiconductor substrate (10), the body region (27) forming a pn junction (28) with the semiconductor material of the semiconductor substrate (10) at a depth dₚₙ from the first major surface (11), and
forming a source region (29) on the body region (27).

2. A method according to claim 1, further comprising:
determining a depth dᵣ₁ of the recess (21);
comparing the determined depth dᵣ₁ to a predetermined depth dᵣ, and
further removing the second insulating layer (20) using wet chemical etching and increasing the depth of the recess (21).

3. A method according to claim 2, further comprising adjusting a composition of the wet chemical etch and/or an etching condition responsive to the determined depth.

4. A method according to claim 1, wherein the chemical mechanical polishing comprises using a slurry having a polish selectivity of the second insulating layer (20) over the semiconductor substrate (10) of 100 to 1.

5. A method according to one of claims 1 to 4, wherein the second insulating layer (20) is applied using High Density Plasma deposition.

6. A method according to one of claims 1 to 5, wherein the removing the second insulating layer (20) from the trench (12) by wet chemical etching comprises exposing semiconductor material at the side wall (14) of the trench above the first conductive material (18), the first conductive material (18) being covered by the second insulating material (20).

7. A method according to one of claims 1 to 6, wherein the first insulating layer (17) and the second insulating (20) layer comprise silicon oxide, the semiconductor substrate (10) comprises silicon and the first conductive material (18) comprises polysilicon.

8. A method according to any one of claims 1 to 7, wherein the method is carried out for a plurality of trenches essentially simultaneously and the gate electrodes (26) have a lower surface positioned at a depth d_{g} from the first major surface (11) and a variation in the difference between the depth dₚₙ and depth d_{g} for the plurality of trenches is less than 8% of d_{g}.

## Patentansprüche

1. Verfahren zur Bildung einer isolierten Feldplatte in einem Graben und einer Vertiefung (21) für eine isolierte Gate-Elektrode (26) in dem Graben, umfassend:
Bilden eines Grabens (12) in einer ersten Hauptfläche (11) eines Halbleitersubstrats (10), wobei der Graben (12) eine Basis (13) und eine Seitenwand (14) aufweist, die sich von der Basis (13) zu der ersten Hauptfläche (11) erstreckt;
Bilden einer ersten Isolationsschicht (17) auf der Basis (13) und der Seitenwand (14) des Grabens (12);
Einbringen eines ersten leitfähigen Materials (18) in den Graben (12), das die erste Isolationsschicht (17) zumindest teilweise bedeckt, um eine Feldplatte (19) in einem unteren Abschnitt des Grabens (12) zu bilden, wobei das Einbringen des ersten leitfähigen Materials (18) Folgendes umfasst:
Füllen des Grabens (12) mit dem ersten leitfähigen Material (18) und Aufbringen des ersten leitfähigen Materials (18) über der ersten Hauptfläche (11), und
Entfernen des ersten leitfähigen Materials (18) von der ersten Hauptfläche (11) und von einem oberen Abschnitt des Grabens (12), um die Feldplatte (19) in dem unteren Abschnitt des Grabens zu bilden, und
vollständiges Entfernen der ersten Isolationsschicht (17) von der Seitenwand (14) an einem oberen Abschnitt des Grabens (12) nach der Bildung der Feldplatte (19), um das Halbleitermaterial des Halbleitersubstrats (10) freizulegen;
Aufbringen einer zweiten Isolationsschicht (20) auf die erste Hauptfläche (11) und den Graben (12), so dass die zweite Isolationsschicht (20) den Graben (12) füllt und das leitfähige Material (18) bedeckt;
Entfernen der zweiten Isolationsschicht (20) von der ersten Hauptfläche (11);
teilweises Entfernen der zweiten Isolationsschicht (20) aus dem Graben (12) durch nasschemisches Ätzen und Bilden einer Vertiefung (21) für eine Gate-Elektrode (26) in der zweiten Isolationsschicht (20) in dem Graben (12),
wobei die zweite Isolationsschicht (20) durch chemischmechanisches Polieren selektiv von der ersten Hauptfläche (11) entfernt wird und die erste Hauptfläche (11) des Halbleitersubstrats (10) als Ätzstopp wirkt, und das Verfahren ferner Folgendes umfasst:
Bilden einer dritten Isolationsschicht (23) auf der freiliegenden Seitenwand (22), und
Einbringen eines zweiten leitfähigen Materials (25) in die Vertiefung, um eine Gate-Elektrode (26) in einem oberen Abschnitt des Grabens (12) zu bilden, und
nach dem Bilden der Gate-Elektrode (26) Bilden eines Body-Gebiets (27) eines zweiten Leitfähigkeitstyps durch Implantation in die erste Hauptfläche (11) des Halbleitersubstrats (10), wobei das Body-Gebiet (27) in einer Tiefe dₚₙ von der ersten Hauptfläche (11) einen pn-Übergang (28) mit dem Halbleitermaterial des Halbleitersubstrats (10) bildet, und
Bilden eines Source-Gebiets (29) auf dem Body-Gebiet (27) .

2. Verfahren nach Anspruch 1, ferner umfassend:
Bestimmen einer Tiefe dᵣ₁ der Vertiefung (21);
Vergleichen der bestimmten Tiefe dᵣ₁ mit einer vorbestimmten Tiefe dᵣ und
weiteres Entfernen der zweiten Isolationsschicht (20) unter Verwendung nasschemischen Ätzens und Vergrößern der Tiefe der Vertiefung (21).

3. Verfahren nach Anspruch 2, ferner umfassend Anpassen einer Zusammensetzung der nasschemischen Ätzung und/oder einer Ätzbedingung in Reaktion auf die bestimmte Tiefe.

4. Verfahren nach Anspruch 1, wobei das chemischmechanische Polieren Verwenden einer Suspension mit einer Polierselektivität der zweiten Isolationsschicht (20) über dem Halbleitersubstrat (10) von 100 bis 1 umfasst.

5. Verfahren nach einem der Ansprüche 1 bis 4, wobei die zweite Isolationsschicht (20) unter Verwendung von Abscheidung von Plasma hoher Dichte aufgebracht wird.

6. Verfahren nach einem der Ansprüche 1 bis 5, wobei das Entfernen der zweiten Isolationsschicht (20) aus dem Graben (12) durch nasschemisches Ätzen Freilegen von Halbleitermaterial an der Seitenwand (14) des Grabens über dem ersten leitfähigen Material (18) umfasst, wobei das erste leitfähige Material (18) von dem zweiten Isolationsmaterial (20) bedeckt ist.

7. Verfahren nach einem der Ansprüche 1 bis 6, wobei die erste Isolationsschicht (17) und die zweite Isolationsschicht (20) Siliciumoxid umfassen, das Halbleitersubstrat (10) Silicium umfasst und das erste leitfähige Material (18) Polysilicium umfasst.

8. Verfahren nach einem der Ansprüche 1 bis 7, wobei das Verfahren für eine Mehrzahl von Gräben im Wesentlichen gleichzeitig durchgeführt wird und die Gate-Elektroden (26) eine untere Oberfläche aufweisen, die in einer Tiefe d_{g} von der ersten Hauptfläche (11) positioniert ist, und eine Abweichung der Differenz zwischen der Tiefe dₚₙ und der Tiefe d_{g} für die Mehrzahl von Gräben weniger als 8 % von d_{g} beträgt.

## Revendications

1. Un procédé de formation d'une plaque de champ isolée dans une tranchée et d'une cavité (21) pour une électrode (26) de grille isolée dans la tranchée, comprenant :
former une tranchée (12) dans une première surface (11) principale d'un substrat (10) de semiconducteur, la tranchée (12) ayant une base (13) et une paroi (14) latérale, s'étendant de la base (13) à la première surface (11) principale ;
former une première couche (17) isolante sur la base (13) et la paroi (14) latérale de la tranchée (12) ;
insérer un premier matériau (18) conducteur dans la tranchée (12), qui recouvre au moins en partie la première couche (17) isolante pour former une plaque (19) de champ dans une partie inférieure de la tranchée (12), dans lequel l'insertion du premier matériau (18) conducteur comprend :
remplir la tranchée (12) du premier matériau (18) conducteur et appliquer le premier matériau (18) conducteur sur la première surface (11) principale, et
retirer le premier matériau (18) conducteur de la première surface (11) principale et d'une partie supérieure de la tranchée (12) pour former la plaque (19) de champ dans la partie inférieure de la tranchée, et
après la formation de la plaque (19) de champ, la première couche (17) isolante est retirée entièrement de la paroi (14) latérale à une partie supérieure de la tranchée (12) pour mettre à découvert le deuxième matériau semiconducteur du substrat (10) de semiconducteur ;
appliquer une deuxième couche (20) isolante à la première surface (11) principale et à la tranchée (12), de manière à ce que la deuxième couche (20) isolante remplisse la tranchée (12) et recouvre le matériau (18) conducteur ;
retirer la deuxième couche (20) isolante de la première surface (11) principale ;
retirer partiellement la deuxième couche (20) isolante de la tranchée (12) par attaque chimique en voie humide et former une cavité (21) pour une électrode (26) de grille dans la deuxième couche (20) isolante dans la tranchée (12), dans lequel la deuxième couche (20) isolante est retirée sélectivement de la première surface (11) principale par polissage chimique, mécanique et la première surface (11) principale du substrat (10) de semiconducteur sert d'arrêt d'attaque et le procédé comprenant en outre
former une troisième couche (23) isolante sur la paroi (22) latérale mise à découvert, et
insérer un deuxième matériau (25) conducteur dans la cavité pour former une électrode (26) de grille dans une partie supérieure de la tranchée (12), et
après avoir formé l'électrode (26) de grille, former une région (27) de corps d'un deuxième type de conductivité par implantation dans la première surface (11) principale du substrat (10) de semiconducteur, la région (27) de corps formant une jonction (28) pn avec le matériau semiconducteur du substrat (10) d'un semiconducteur à une profondeur dₚₙ à partir de la première surface (11) principale, et
former une région (29) de source sur la région (27) de corps.

2. Un procédé suivant la revendication 1, comprenant en outre :
déterminer une profondeur dᵣ₁ de la cavité (21) ;
comparer la profondeur dᵣ₁ déterminée à une profondeur dᵣ déterminée à l'avance, et
retirer en outre la deuxième couche (20) isolante en utilisant une attaque chimique en voie humide et en augmentant la profondeur de la cavité (21).

3. Un procédé suivant la revendication 2, comprenant en outre régler une composition de l'attaque chimique en voie humide et/ou d'une condition d'attaque en réaction à la profondeur déterminée.

4. Un procédé suivant la revendication 1, dans lequel le polissage chimique mécanique comprend utiliser une suspension ayant une sélectivité de polissage de la deuxième couche (20) isolante sur le substrat (10) de semiconducteur de 100 à 1.

5. Un procédé suivant l'une des revendications 1 à 4, dans lequel la deuxième couche (20) isolante est appliquée en utilisant un dépôt au plasma de grande densité.

6. Un procédé suivant l'une des revendications 1 à 5, dans lequel le retrait de la deuxième couche (20) isolante de la tranchée (12) par attaque chimique en voie humide comprend mettre à découvert du matériau semiconducteur à la paroi (14) latérale de la tranchée au-dessus du premier matériau (18) conducteur, le premier matériau (18) conducteur étant recouvert du deuxième matériau (20) isolant.

7. Un procédé suivant l'une des revendications 1 à 6, dans lequel la première couche (17) isolante et la deuxième couche (20) isolante comprennent de l'oxyde de silicium, le substrat (10) de semiconducteur comprend du silicium et le premier matériau (18) conducteur comprend du polysilicium.

8. Un procédé suivant l'une quelconque des revendications 1 à 7, dans lequel on effectue le procédé pour une pluralité de tranchées sensiblement simultanément et les électrodes (26) de grille ont une surface inférieure positionnée à une profondeur d_{g} à partir de la première surface (11) principale, et une variation de la différence entre la profondeur dₚₙ et une profondeur d_{g} pour la pluralité de tranchées est inférieure à 8 % de d_{g}.
